# EUROPEAN PATENT SPECIFICATION

(11) **EP 1 966 805 B1**
(45) Date of publication and mention of the grant of the patent: **11.03.2009**
(21) Application number: 06831723.9
(22) Date of filing: 15.12.2006
(51) Int. Cl.: H01B 1/12, H01B 1/20, C09D 11/00, B42D 15/10

(54) **FORMULATION AND PROCESS OF PRODUCING CONDUCTIVE FILM ELEMENTS**
FORMULIERUNG UND PROZESS ZUM HERSTELLEN LEITFÄHIGER FILMELEMENTE
FORMULATION ET PROCEDE DE PRODUCTION D ELEMENTS DE FILMS CONDUCTEURS

(30) Priority: 19.12.2005 EP 05425897
(43) Date of publication of application: 10.09.2008
(73) Proprietor: Kiian S.p.A., 22070 Luisago (CO) (IT)
(72) Inventor: MANOUKIAN, Harutiun, I-22070 Luisago (CO) (IT); CIMATTI, Marco, I-22070 Luisago (CO) (IT)
(74) Representative: Valentini, Giuliano
(86) International application number: PCT/IB2006/003631
(87) International publication number: WO 2007/072148

(56) References cited:
- EP-A- 1 229 088
- US-A1- 2005 045 856
- PATENT ABSTRACTS OF JAPAN vol. 2003, no. 12, 5 December 2003 (2003-12-05) & JP 2004 161842 A (GODO INK KK), 10 June 2004 (2004-06-10)

## Description

### Field of the invention

The present invention relates to a composition and process for manufacturing conductive film elements.

More particularly, the invention relates to a chemical composition in the form of ink which can be applied by means of printing, or other similar processes, to a substrate, such as for example a film or the like.

Following subsequent treatments, a composition according to the invention can be advantageously used for obtaining conductive elements in the form of defined drawing areas such as lines, letters, numbers, symbols, mono- and bi-dimensional barcodes, antennas intended for example to radiofrequency identification (RFID), geometrical shapes and the like.

### Background Art

The so-called conductive ink formulations have been known for a long time. These inks include compounds being capable of giving the required conductivity and a binding resin in order to provide the characteristics of printability on various substrates and ink film resistance after it has been printed.

Conductive inks based on metal particles, such as either silver or tin/lead provide high-conductivity elements and with resistance values ranging between about 0,2 and about 50-60 Ohm. Graphite-based inks having high resistance values, between 10² MOhm and 10⁴ MOhm, and also quaternary ammonium salt-based inks with resistance values which are even much higher than inks with graphite are also known.

These compositions are applied with conventional printing systems such as screen printing and rotogravure printing on various supports, particularly polyester, in order to obtain printed circuits and RFID antennas which widely apply to the industrial use.

Known compositions for conductive inks have excellent conductivity characteristics, but on the other hand they have a series of problems relating either to the application or printing systems.

Due to the available granulometry and the high specific weight, metal-based compositions are suitable to be almost exclusively printed by means of a screen printing system and with frames having an end count which is somewhat small: this results in a quite coarse reproduction accuracy of the contours in image printing, as well as track and lead miniaturizations under certain sizes may not be easily carried out. Moreover, screen printing does not allow high production speeds.

The graphite-base inks can be printed with rotogravure system, i.e. quickly and with high reproduction accuracy. However, in order to obtain sufficient accuracy, cylinders are required having rather high rulings and with reduced etching depth.

These restrictions result in a reduced thickness deposited on the substrate and, since the Ohm resistance increases upon the decrease in the track section and the graphite-base inks have limited conductivity, the conductivity results of the thus-obtained circuits are unsatisfactory.

EP 1229088 A1 discloses a method for the preparation of an electrically conductive ink or paint starting from aniline or an aniline derivative. After a polymerization step, the obtained polyaniline polymer is aggregated by removing any liquid component in order to obtain a solid component which is dispersed in a synthetic resin solution.

JP 2004-161842 A discloses a a conductive ink based on a polyaniline polymer which is obtained by reacting aniline or an aniline derivative with an acid. The polyaniline polymer is admixed with a binder and subjected to separate steps of dehydration for separating water from the ink component. The conductive ink so obtained is used for manufacturing conductive parts such as a non-contact IC card or a physical distribution tag for RFID.

In general, it can be asserted that the weakness of the processes mentioned above is that the chemical products required for the process are developed in order to be applied by means of traditional printing techniques which offer good performance only if the inks have specific characteristics of adaptability to the system.

In practice, the adaptability requirement is in conflict with the need for formulating at the same time an ink containing large amounts of conductive materials; the result is the search for the better compromise between printing needs and high conductivity.

Alternatively to the above-mentioned inks, processes are known which provide the full-background deposition of special non-conductive photoresist films on substrates in the form of about 1 mm-thick plates, consisting of either phenolic or epoxy resin and covered with metallic copper, having 35 micron in thickness or more, on either or both sides.

These resist films are photo-crosslinkable, and after they have been applied onto the substrate, they are dried and then exposed to the UV light through a photo mask, so that those parts that are hit by the light polymerize whereas those not exposed remain in the original state.

A subsequent alkaline bath dissolves the soluble parts, because they have not polymerized, thus leaving the original copper selectively exposed, according to the photographic transparency, which is then removed with a ferric perchloride bath. Thereby, copper tracks are obtained, those protected by the resist, corresponding to those provided on the mask, with high accuracy and with excellent conductive characteristics.

The process described above uses complicated and expensive production lines and also requires considerable efforts in order to reduce possible environmental damage due to the presence of metals and several aggressive chemical agents that are required for etching the metals.

A further drawback which is common to known systems for printing conductive elements is the absence of printing flexibility. In fact, the use of a master is required, which is reproduced for a varying number of copies and needs to be removed and replaced with another master every time the print images are required to be replaced. This leads to an increase in the processing time and costs when run decreases with the consequent increase in master replacements. Furthermore, masters are an additional cost.

Therefore, there is the need for a printing system for conductive elements with high conductivity characteristics and capable of being manufactured by high-speed printing and having a high level of flexibility in order to allow various configurations to be defined during the printing, and without stopping the production lines.

### Summary of the Invention

The object of the present invention is to satisfy the need mentioned above, by taking into account the required characteristics of conductivity and need for reproduction accuracy, the need and possibility to diversify the printed models during the printing, a reduced environmental impact, all of them at industrially acceptable rates.

This object is achieved by means of the present invention which relates to a composition for conductive inks characterized according to claim 1.

The invention further relates to a process for manufacturing printed conductive elements characterized according to claim 9.

A further object of the invention is a substrate having at least one portion coated with the above-mentioned composition, i.e. a substrate to which one or more areas of conductive composition have been applied, without depolymerization treatment of portions of the conductive area.

A further object of the invention is a substrate having said portion coated with conductive composition, where some predetermined zones of the area covered with conductive composition have been made non-conductive, or partially conductive, by means of either laser radiation or other depolymerization treatment.

As mentioned above, the ink composition according to the invention comprises at least one resin or similar product having the function of a binding matrix and one or more conductive materials dissolved in said binding resin. One of the conductive materials is a conductive (co)polymer which can be at least partially depolymerizable either by laser radiation or other coherent and focused energy source. Preferably, the conductive (co)polymer is a polyaniline polymer.

The composition according to the invention further comprises conductive mineral fillers (such as coated mica) in such amounts as not to make the composition conductive by themselves. In other words, the fillers are electrically connected to each another by means of the conductive polymer.

According to the invention, the circuit (or other desired "drawing") is obtained by depolymerising that portion of conductive coating which is not involved in the circuit. That part which has not been depolymerised is still conductive and forms the required circuit.

The invention has several advantages as compared with the prior art. First of all, it allows to obtain high accuracy in making the circuit lines. Moreover, manufacture may be carried out at very high speeds, i.e. at the usual printing speeds of a flexographic machine, for example.

Another advantage is that the process is totally free of problems from the environmental viewpoint: in fact, no material is removed in order to obtain the tracks of the desired circuit.

Yet another advantage is the possibility of modifying the laser depolymerization paths on the conductive area in order to obtain different final products, with no need for the master to be replaced, i.e. the cylinder (or sleeve) applying the composition according to the invention to the substrate.

### Brief Description of the Drawings

The invention will be now described in greater detail with reference to the following drawing, which is given by way of illustrative and non-limiting example, in which:

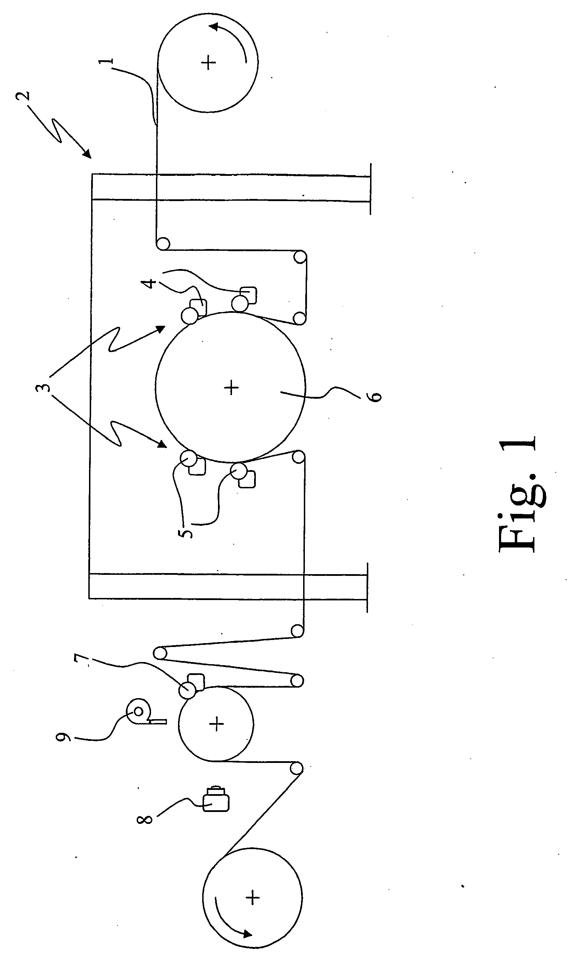

- Fig. 1 is a diagram of an equipment for printing elements according to the invention.

### Modes for Carrying Out the Invention

The binding matrix used in the composition according to the invention is a chlorinated compound and is preferably the product deriving either from the chlorination of natural rubber or synthetic rubbers such as butyl rubber, polybutadiene rubber, polychloroprene rubber, or even derivatives from the chlorination of polyolefin, or mixtures of two or more of said chlorinated resins.

The chlorinated resins and rubbers used in the invention are characterized by a chlorine content which can range between 50% and 75% by weight, preferably ranging between 61 % and 65% by weight. By way of example, the general formula (1) of the chlorinated compound is

(-CH₂-CCl=CH-CH₂-)ₙ (1)

Trade products that can be used for this purpose are for example various types of CLORTEX available from CAFFARO, particularly CLORTEX 20.

A polymer conductive per se is used to give conductivity to the film and create a non-stop conductive film: According to the invention, the conductive polymer has to be capable of depolymerising when it is irradiated with any coherent, mostly single frequency light source, such as a laser light or the like as produced by commercially available equipment, or even by laser emission diodes or the like.

Preferred types of conductive polymers for use with the invention are polyanilines. These polymers have the general formula (2) as set forth herein below and include a repetition of y reduced and y - 1 oxidized groups, particularly the alternating state between the groups (**y = 0.5**) produces the so-called "smeraldine oxidation state".

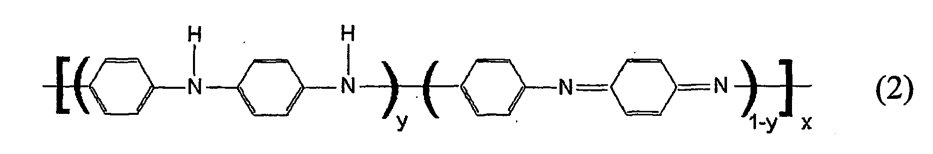

In order to increase the conductivity of the above-mentioned form, recourse can be made to reaction products between polyaniline and doping compositions such as in the case discussed below and mentioned only by way of example.

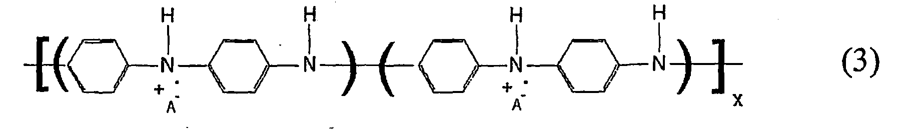

Further information and the characteristics of polyanilines can be easily obtained, for example from: "Polyaniline, a novel class of conductive polymers" by Alan G. MacDiarmid, Department of Chemistry, University of Pennsylvania, Philadelphia, Pennsylvania 19104-6323, USA and by Arthur J.Epsein, Department of Physic and Chemistry, The Ohio State University, Columbus, Ohio 43210-1106, USA.

The amount of polyaniline used in the composition according to the invention ranges between 0.9% and 2.1 % by weight on the finished product and, preferably, ranges between 1.1% and 1.8%.

In the case of products according to formula (3), which are obtained by treating polyaniline with acids, the preferred amounts of polyaniline range between 1.2% and 1.4%, more preferably around 1.25%.

Acids adapted to treat the polyanilines are the derivatives of the sulfonic acid, in amounts ranging between 2% and 10%, preferably 3.1% - 4.5% by weight on the finished product. A preferred acid is the alkylbenzen-sulfonic acid, which is preferably used in the range between 3.4% - 3.8% by weight and, more preferably around 3.65% by weight on the finished product.

As regards the conductive polymers, trade products that can be used in the composition according to the invention are for example the PANIPOL classes, particularly PANIPOL T, which are manufactured by PANIPOL Oy, a Finnish company.

According to a preferred aspect of the invention inorganic fillers, in particular conductive mineral fillers, are also provided in order to improve the conductivity of the film obtained by applying the composition to a substrate.

The combination of these fillers with the organic conductive polymer provides a continuous surface with conductivity characteristics due both to the filler particles and the polymer which, in turn, envelops the particles and connects them to each other in an intimate and continuous manner.

Preferred conductive mineral fillers for use with the composition according to the invention consist of micas, i.e. complex aluminium and potassium silicates which sometimes also include variable proportions of magnesium, iron, lithium, fluorine and hydroxyls. Either natural or synthetic mica can be used, the selection within the class being dictated by the required conductivity requirements.

By way of example, a general formula for mica is as follows:

KAl₂[(OH,F)₂AlSi₃O₁₀] (4)

In the present case, a mica having scales coated with tin and antimony oxide is preferably used.

Mica scale coating is a process known per se and is not the object of the present invention; commercially available products belonging to the class of the transparent conductive micas coated with tin and antimony oxide are for example MINATEC 31 produced by MERCK.

The weight amount of coated mica provided on polyaniline ranges between 5% and 50%, and more preferably 18%-27%.

As mentioned above, the process according to the present invention preferably provides a full-background coating of the composition described above followed by quick drying and, both in line and at the line speed and subsequently, image printing by means of exposure to light radiation, such as provided by a laser beam that reproduces a desired image by inhibiting the conductivity of those areas outside the drawings to be carried out.

This is possible because the composition applied to the support film reacts in split seconds to the energy emitted by the laser, particularly the energetic level is such that the conductive polymer is at least partially depolymerised with subsequent conductivity loss, which is not only due to the polymer fraction, but also of the mica particles which are no longer interconnected with one another. By suitably modulating the power irradiated by the light source and/or the exposure time of the composition, areas with desired resistivity values can be obtained.

It is particularly significant and advantageous that those areas-that have been hit by the laser do not "lose" material by physical ablation, because it is the conductive polymer, and namely the polyaniline, which is inhibited in conduction due to the demolition of the above-mentioned polymer chains.

The process may be also defined "clean", since image printing, unlike with photoresists, does not require development baths; in fact, all what has been deposited during the printing step remains on the base support because the image is generated by a change of state of the conductive film without removal of the material.

Thereby, image printing with excellent characteristics is ensured. Moreover, the absence of combustion residues which could deposit on the processed film has been noticed.

As mentioned above, in order to obtain a printed product by using a composition of the type described above, the present invention proposes a process in which the mentioned composition is applied to a substrate, and then the substrate and/or composition deposited thereon is dried.

The composition can be either full-background applied to the substrate or on predetermined portions of the latter, in the form of a layer having predetermined thickness such that an intermediate product is obtained which is intended for subsequent use, for example winding of the printed film in the form of a reel for later processing.

The application can be carried out either on a plastic or paper substrate, such as for example a film or the like, which may also be already printed with conventional inks. Alternatively, the application can be carried on output from the printing machine, and hence in line with the printing process.

In order to obtain a final printed product, there is provided the radiation of selected portions of the composition layer applied to the substrate with light beams produced by a coherent light source. The radiation allows to at least partially depolymerise the conductive polymer in the selected portions and inhibit the conductivity thereof.

Particularly, the change in surface state occurs because the composition is exposed to the light beam, which is preferably produced by a focalized laser line source. The energy induced onto the surface of the composition applied to the substrate causes the change of state thereof and the movement of the source and/or the material causes the geometry of the change of state.

The laser source emission is focused on the composition surface by means of one or more static or dynamic, fixed- or changeable-focal lens systems (or groups), in order to allow different focusing diameters and/or the focusing on surfaces with different thickness, however changeable or complex, of which the surface definition is known.

The laser source may be either a solid-state (e.g. semiconductor, and the like), sealed gas discharge or open gas discharge: the type of light emission and mode of use will be characterized by the construction typology, whereas the emission power will take part in determining the energy delivered to the composition during the surface changing step.

The light emission may be either of the continuous or pulsed type. In the latter case, the pulsation can be either natural, i.e. generated by the physical structure of the source, or of an induced type by means of intracavity modulators and/or external to the source.

In brief, the surface change of state is hence caused by the interaction between the composition and the energy delivered by the laser source and focused on the surface. The characteristics of the source, particularly the wavelength(s), source power, focal diameter and exposure rate (which determine together the energy of surface change of state) are characteristic parameters based on which the compatibility is established between the "composition" system and a "laser" system capable of either causing the change of state or not.

The geometry of the change of state of the composition is obtained through the relative movement of the material relative to the focused coherent light source. The relative shifting can be provided by different techniques, such as for example:
1. galvanometric scanning of the surface by means of theta lens focusing (X/Y-axes moved by galvanometers or similar electromechanical actuators and optical Z-axis);
2. galvanometric scanning of the surface by means of dynamic focusing (dynamic X/Y/Z-axes moved by galvanometric system or similar electromechanical actuators);
3. surface scanning by means of rotating polygonal mirror and focusing theta lens (X-axis scanned with polygonal mirror, Y-axis material movement, Z-axis theta lens);
4. surface scanning either by means of X/Y or X/Y/Z movement of the laser source;
5. surface scanning either by means of X/Y or X/Y/Z movement of the surface onto which the composition is applied or onto the composition itself, either in the solid or liquid form;
or however based on the combination of one or more of these techniques.

The geometry of the change of state is constructed, for example, from electronic information defining the action areas of the laser source: This information can be either in scalable vectorial- (as a sequence of the movements to be made) or raster form, i.e. in "pixel" graphic form. In both cases the scanning unit will make the movements required to form the images of the change of state on the composition.

With reference to Fig. 1, a substrate 1 consisting of a film made of a plastic material, such as selected from PVC, PET, PETG and PES, in the form of reel (even thousands of metres long) with thickness ranging between 20 and 30 microns and more, is mounted upstream of a flexographic printing machine 2, in a known manner.

The film 1 is supplied to the machine 2 and passed through one or more printing units 3 arranged around a central drum 6, each carrying a master 5 picking up from an ink tank 4, each of them applying a different colour to the film 1.

The printing speed usually ranges between 50 and 400 metres per minute; drying stations (not shown), for example either IR or forced-air hot ventilation stations, cause the various steps to dry before the very next colour is applied.

An additional station is arranged in line with the printing machine, which comprises at least one printing unit 7 for applying the composition being the object of this patent on predetermined areas of the film 1, which has been previously decorated with graphic inks, drying means 9 being included.

Downstream of the printing assembly applying the conducting-ink composition according to the invention, there is arranged at least one laser 8 marking those areas carrying the conductive composition printing by selective depolymerization of the composition, thus creating the predetermined codes. The film 1, being provided with the required codes and the depositions of the predetermined number of colours, is then rewound downstream of the machine.

Alternatively, the film printed with the colours and already provided with the conductive composition areas is only subsequently rewound and treated with the laser, upon manufacturing of the final packaging.

Therefore, the printing assembly for applying the conductive composition, a laser equipment for selectively depolymerising a part of the area coated with said composition, as well as the printing machines and the packaging machines comprising said depolymerization assembly are also an object of the present invention.

The present invention further allows obtaining selectively depolymerised areas, either by in-line or offline operation, on tridimensional objects such as bottles, containers, and the like; in this case, the object to be treated will be moved with respect to the laser light source.

Another very interesting feature is that the areas to be depolymerised can be selectively processed not only by site location but also quantitatively, by suitably calibrating the power, frequency, speed and/or etching time of the selected area.

This means that adjacent or faraway areas can be either fully depolymerised, thus providing a zero-conductive film, or can be processed with modulated powers that will produce areas with conductivity intermediate between the specific conductivity of the non-processed areas and that of those areas that have been processed to full depolymerization.

The invention will be now further illustrated with reference to the following examples.

### Example 1 - Preparation of a conductive polymer composition

185.5g of a resin of the chlorinated rubber family, such as CLORTEX 20, is added to 344.5g of toluene under stirring and left stirring to complete solution.

227g of a coated mica, such as MINATEC 31, is added to the above-mentioned solution and left in dispersion for 20 minutes at 1200 rpm under a Cowless stirrer.

After this dispersion time, 243g of a sulfonated-salt-polyaniline solution is added, such as PANIPOL T, and the dispersion is continued for 10 minutes at the same conditions mentioned above.

The dispersed product is then placed in a TURBOMILL or SUBMILL grinding mill; the granulometry of the product being ground is controlled by means of grindometer until 2 micron size or less is obtained. During the grinding process the product is maintained at a temperature lower than 50°C.

The finished product corresponds to a product performing as mentioned in this document, and claimed herein.

### Example 2 - Creation of mono- or bi-dimensional barcodes on flexible-film packaging.

A 30 micron-thick PET film is printed in a four-colour flexographic machine, at 100 m/min speed to provide a base for manufacturing a packaging.

A 1 cm² area of a conductive composition according to the Example 1 is applied evenly spaced on the film such as to obtain one of said areas on each final product.

After drying, the area is partially depolymerised by treatment with YAG laser line. The characteristics of the code obtained are the following:
- no processing residue
- clear separation between the conductive areas and the insulating areas
- good geometry definition
- unchanged conductivity

### Example 3 - Full-background printing with high thickness of the composition and creation of the graphic symbols in-line with the printing machine.

The conductive composition is uniformly coated at high thickness by means of a roller coater, i.e. with 10 or more microns in thickness, all over the surface of a substrate consisting of a plastic film and dried in a manner known per se.

On output from the machine, a laser with power that can be adjusted up to 20W, YAG source, draws the required element, continuously and in negative, by means of selective depolymerization of the polyaniline in the composition on those areas that will define the desired drawings. The non-radiated portions will provide the required conductive element.

Subsequent processing will exploit the printed area by means of cutting operations, embossing, transfer applications or film insertion in other plastic or paper supports.

The coating step may be also carried out with machines which are different from the one mentioned above, for example either with a roller coater carrying raster cylinders or with a multipoint etching, and either on paper supports or other materials.

## Claims

1. A composition for conductive inks, comprising a resin with the function of a binding matrix and one or more conductive materials dispersed in said binding resin, wherein said conductive materials include a polyaniline polymer, **characterized in that** said conductive materials further include a conductive mineral filler comprising at least one complex silicate selected from micas, either natural or synthetic, or mixtures thereof, and **in that** said polyaniline polymer can be at least partially depolymerised by radiation by means of light beams produced by a coherent light source.

2. The composition according to claim 1, wherein said polyaniline polymer has the general formula

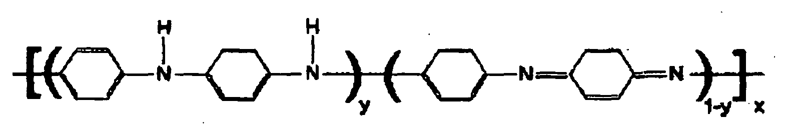

3. The composition according to claim 1, wherein said polyaniline polymer is reacted with doping compositions to provide compounds with general formula

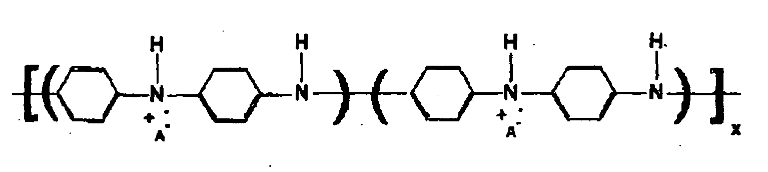

4. The composition according to one of the preceding claims, wherein said binding resin is selected from chlorinated natural rubbers, chlorinated synthetic rubbers, chlorinated polyolefins and mixtures thereof.

5. The composition according to claim 4, wherein said chlorinated resin has a chlorine content ranging between 50% and 75% by weight.

6. The composition according to claim 1, wherein said mica is a mica coated with tin and antimony oxide and is present between 5% and 50% by weight.

7. A process for manufacturing conductive elements by printing, **characterized by** applying a layer of the composition according to one of the preceding claims to a substrate, drying said substrate and irradiating selected portions of said composition layer with light beams produced by a coherent light source in order to at least partially depolymerise said conductive polymer and inhibit the conductivity thereof in said selected portions.

8. The process according to claim 7, herein said coherent light source is a focused laser light source.

9. The process according to claim 7, wherein said coherent light source emits light having a wavelength included in the neighbourhood of at least one predetermined wavelength.

10. The process according to claim 7, wherein said coherent light source is a laser source selected between solid-state and gas-discharge laser.

11. The process according to claim 7, wherein said coherent light source produces a light emission selected between continuous and pulsed.

12. The process according to claim 11, wherein said pulsed light emission is obtained by means of natural pulses of said coherent light source.

13. The process according to claim 7, wherein the light emission of said coherent light source is adjusted by changing at least one of the parameters comprising the emission power, emission pulse frequency, speed and/or time of composition exposure in order to obtain areas with conductivities intermediate between the specific conductivity of the non-processed areas and that of those areas that have been processed to full depolymerization.

14. A printed substrate, **characterized by** comprising at least one portion coated with a composition according to one of claims 1 to 6.

15. The printed substrate according to claim 14, wherein selected portions of said portion printed with said composition are non-conductive and depolymerized.

16. A printed product obtained by means of a process according to any of claims 7 to 13.

17. An apparatus for manufacturing conductive elements according to the process of one of claims 7 to 13, **characterized by** comprising a depolymerization unit including a coherent light source in order to irradiate a composition layer according to one of claims 1 to 6.

18. A printing machine, **characterized by** comprising at least one apparatus according to claim 17 and at least a printing unit for applying a composition layer according to one of claims 1 to 6 on a substrate.

19. A conductive element obtained from a composition according to one of claims 1 to 6, comprising one or more non-conductive depolymerized portions arranged adjacent to said conductive element.

## Patentansprüche

1. Eine Zusammensetzung für leitende Druckfarben, umfassend ein Harz mit der Funktion einer Bindematrix und einem oder mehreren in dem Harz dispergierten leitenden Material(ien), wobei die leitenden Materialien ein Polyanilinpolymer enthalten, **dadurch gekennzeichnet, dass** die leitenden Materialien weiterhin einen leitenden mineralischen Füllstoff enthalten, der mindestens ein komplexes Silikat ausgewählt aus Glimmer umfasst, entweder natürlicher oder synthetischer Herkunft oder Mischungen davon, und dass das Polyanilinpolymer zumindest teilweise durch Bestrahlung mit Lichtstrahlen depolymerisiert sein kann, wobei die Lichtstrahlen von einer phasengleichen Lichtquelle erzeugt werden.

2. Die Zusammensetzung nach Anspruch 1, wobei das Polyanilinpolymer die allgemeine Formel aufweist:

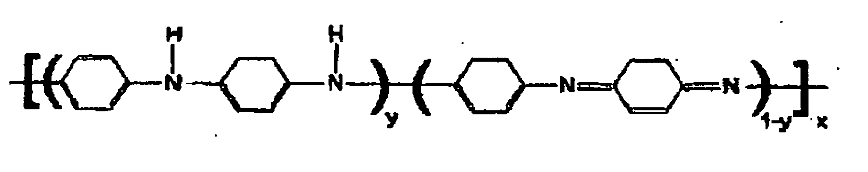

3. Die Zusammensetzung nach Anspruch 1, wobei man das Polyanilinpolymer mit Dotierungsmitteln hat reagieren lassen, um Verbindungen der allgemeinen Formel zu erhalten:

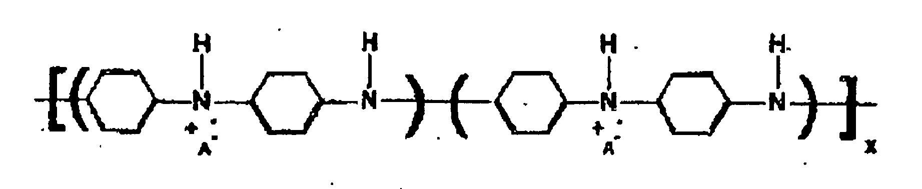

4. Die Zusammensetzung nach einem der vorhergehenden Ansprüche, wobei das Bindeharz ausgewählt ist aus chlorierten Naturkautschuken, chlorierten synthetischen Gummis, chlorierten Polyolefinen und Mischungen davon.

5. Die Zusammensetzung nach Anspruch 4, wobei das chlorierte Harz einen Chlorgehalt im Bereich von 50 Gew.-% bis 75 Gew.-% aufweist.

6. Die Zusammensetzung nach Anspruch 1, wobei der Glimmer mit Zinn- und Antimonoxid beschichtet ist und zu 5 Gew.-% bis 50 Gew.-% enthalten ist.

7. Ein Verfahren zur Herstellung leitender Elemente durch Drucken, **dadurch gekennzeichnet, dass** eine Schicht mit der Zusammensetzung gemäß einem der vorhergehenden Ansprüche auf ein Substrat aufgebracht wird, das Substrat getrocknet wird und ausgewählte Bereiche der Schicht mit der Zusammensetzung mit Lichtstrahlen bestrahlt werden, die von einer phasengleichen Lichtquelle erzeugt werden, um das leitende Polymer zumindest teilweise zu depolymerisieren und dessen Leitfähigkeit in den ausgewählten Bereichen zu hemmen.

8. Das Verfahren nach Anspruch 7, wobei die phasengleiche Lichtquelle eine Lichtquelle für gebündeltes Laserlicht ist.

9. Das Verfahren nach Anspruch 7, wobei die phasengleiche Lichtquelle Licht mit einer Wellenlänge abgibt, die in der Umgebung von zumindest einer vorbestimmten Wellenlänge liegt.

10. Das Verfahren nach Anspruch 7, wobei die phasengleiche Lichtquelle eine Laserlichtquelle ist, ausgewählt aus Festkörperlaser und Gasentladungslaser.

11. Das Verfahren nach Anspruch 7, wobei die phasengleiche Lichtquelle eine Lichtausstrahlung erzeugt, ausgewählt aus kontinuierlicher und gepulster Lichtausstrahlung.

12. Das Verfahren nach Anspruch 11, wobei die gepulste Lichtausstrahlung mittels natürlicher Pulse der phasengleichen Lichtquelle erzeugt wird.

13. Das Verfahren nach Anspruch 7, wobei die Lichtausstrahlung der phasengleichen Lichtquelle durch Änderung von zumindest einem der Parameter umfassend Strahlungsleistung, Pulsfrequenz der Strahlung, Geschwindigkeit und/oder Zeit der Bestrahlung der Zusammensetzung, geändert werden kann, um Bereiche mit Leitfähigkeiten zu erhalten, die zwischen der spezifischen Leitfähigkeit der nicht-bearbeiteten Bereiche und der Leitfähigkeit solcher Bereiche liegen, die vollständig depolymerisiert wurden.

14. Ein bedrucktes Substrat, **dadurch gekennzeichnet, dass** dieses zumindest einen Bereich umfasst, der mit der Zusammensetzung nach einem der Ansprüche 1 bis 6 beschichtet ist.

15. Das bedruckte Substrat nach Anspruch 14, wobei ausgewählte Teile dieses Bereiches, der mit der Zusammensetzung bedruckt ist, nicht leitend und depolymerisiert sind.

16. Ein bedrucktes Substrat, das mit einem Verfahren gemäß irgend einem der Ansprüche 7 bis 13 erhalten wird.

17. Ein Apparat zur Herstellung leitender Elemente gemäß dem Verfahren nach einem der Ansprüche 7 bis 13, **dadurch gekennzeichnet, dass** dieser eine Depolymerisierungseinheit einschließlich einer phasengleichen Lichtquelle umfasst, um eine Schicht mit der Zusammensetzung nach einem der Ansprüche 1 bis 6 zu bestrahlen.

18. Eine Druckmaschine, **dadurch gekennzeichnet, dass** diese zumindest einen Apparat nach Anspruch 17 umfasst und zumindest eine Druckeinheit zum Auftragen einer Schicht mit der Zusammensetzung gemäß einem der Ansprüche 1 bis 6 auf das Substrat.

19. Eine leitendes Element, das aus einer Zusammensetzung gemäß einem der Ansprüche 1 bis 6 erhalten wird, umfassend einen oder mehrere nicht leitende depolymerisierte Bereiche, die benachbart zu dem leitenden Element aufgebracht sind.

## Revendications

1. Composition pour encres conductrices, comprenant une résine ayant la fonction d'une matrice liante et un ou plusieurs matériaux conducteurs dispersés dans ladite résine liante, dans laquelle lesdits matériaux conducteurs comprennent un polymère de polyaniline, **caractérisée en ce que** lesdits matériaux conducteurs comprennent en outre une charge minérale conductrice comprenant au moins un silicate complexe choisi parmi les micas, soit naturels soit synthétiques, et leurs mélanges, et **en ce que** ledit polymère de polyaniline peut être au moins partiellement dépolymérisé par irradiation au moyen de faisceaux lumineux produits par une source de lumière cohérente.

2. Composition selon la revendication 1, dans laquelle ledit polymère de polyaniline répond à la formule générale :

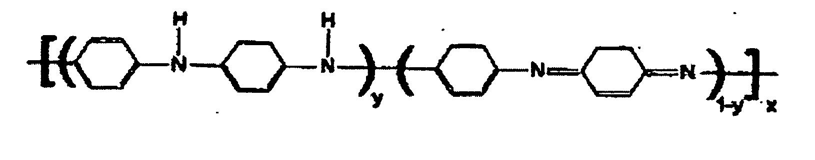

3. Composition selon la revendication 1, dans laquelle ledit polymère de polyaniline est mis à réagir avec des compositions dopantes pour donner des composés de formule générale :

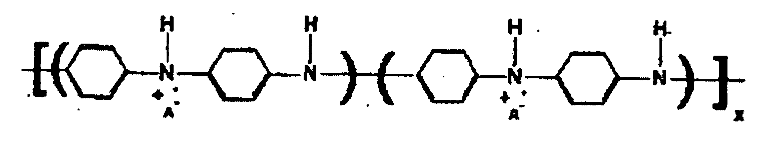

4. Composition selon l'une des revendications précédentes, dans laquelle ladite résine liante est choisie parmi les caoutchoucs naturels chlorés, les caoutchoucs synthétiques chlorés, les polyoléfines chlorées et leurs mélanges.

5. Composition selon la revendication 4, dans laquelle ladite résine chlorée a une teneur en chlore située dans la plage comprise entre 50 % et 75 % en poids.

6. Composition selon la revendication 1, dans laquelle ledit mica est un mica revêtu d'étain et d'oxyde d'antimoine et est présent à raison de 5 % à 50 % en poids.

7. Procédé pour fabriquer des éléments conducteurs par impression, **caractérisé par** l'application à un substrat d'une couche de la composition selon l'une des revendications précédentes, le séchage dudit substrat et l'irradiation de parties sélectionnées de ladite couche de composition avec des faisceaux lumineux produits par une source de lumière cohérente afin de dépolymériser au moins partiellement ledit polymère conducteur et d'inhiber la conductivité de celui-ci dans lesdites parties sélectionnées.

8. Procédé selon la revendication 7, dans lequel ladite source de lumière cohérente est une source de lumière laser focalisée.

9. Procédé selon la revendication 7, dans lequel ladite source de lumière cohérente émet une lumière ayant une longueur d'onde située au voisinage d'au moins une longueur d'onde prédéterminée.

10. Procédé selon la revendication 7, dans lequel ladite source de lumière cohérente est une source de laser choisie parmi un laser à solide et un laser à décharge gazeuse.

11. Procédé selon la revendication 7, dans lequel ladite source de lumière cohérente produit une émission de lumière choisie parmi une émission continue et une émulsion pulsée.

12. Procédé selon la revendication 11, dans lequel ladite émission de lumière pulsée est obtenue au moyen d'impulsions naturelles de ladite source de lumière cohérente.

13. Procédé selon la revendication 7, dans lequel l'émission de lumière de ladite source de lumière cohérente est ajustée par changement d'au moins l'un des paramètres comprenant la puissance d'émission, la fréquence d'impulsion d'émission, la vitesse et / ou le temps d'exposition de la composition, afin que soient obtenues des zones ayant des conductivités intermédiaires entre la conductivité spécifique des zones non traitées et celle des zones qui ont été traitées jusqu'à une dépolymérisation complète.

14. Substrat imprimé, **caractérisé en ce qu'**il comprend au moins une partie revêtue d'une composition selon l'une des revendications 1 à 6.

15. Substrat imprimé selon la revendication 14, dans lequel des parties sélectionnées de ladite partie imprimée avec ladite composition sont non-conductrices et dépolymérisées.

16. Produit imprimé obtenu au moyen d'un procédé selon l'une quelconque des revendications 7 à 13.

17. Dispositif pour fabriquer des éléments conducteurs conformément au procédé de l'une des revendications 7 à 13, **caractérisé en ce qu'**il comprend une unité de dépolymérisation comprenant une source de lumière cohérente afin que soit irradiée une couche de composition selon l'une des revendications 1 à 6.

18. Machine d'impression, **caractérisée en ce qu'**elle comprend au moins un dispositif selon la revendication 17 et au moins une unité d'impression pour appliquer ,sur un substrat une couche de composition selon l'une des revendications 1 à 6.

19. Elément conducteur obtenu à partir d'une composition selon l'une des revendications 1 à 6, comprenant une ou plusieurs parties non-conductrices dépolymérisées disposées adjacentes audit élément conducteur.
